# FASCICULE DE BREVET EUROPEEN

(11) **EP 3 069 156 B1**
(45) Date de publication et mention de la délivrance du brevet: **06.09.2017**
(21) Numéro de dépôt: 14799414.9
(22) Date de dépôt: 14.11.2014
(51) Int. Cl.: G01R 31/40, H01L 31/18

(54) **DISPOSITIF ET PROCEDE DE TEST D'UN MODULE PHOTOVOLTAIQUE A CONCENTRATION**
VORRICHTUNG UND VERFAHREN ZUM TESTEN EINES KONZENTRIERTEN FOTOVOLTAIKMODULS
DEVICE AND METHOD FOR TESTING A CONCENTRATED PHOTOVOLTAIC MODULE

(30) Priorité: 14.11.2013 FR 1361137
(43) Date de publication de la demande: 21.09.2016
(73) Titulaire: Saint-Augustin Canada Electric Inc., Saint-Augustin de Desmaures, Québec G3A 1S5 (CA)
(72) Inventeur: GASTALDO, Philippe, F-38530 Pontcharra (FR); GUILHEM, Mathieu, F-38420 Domene (FR)
(74) Mandataire: Grünecker Patent- und Rechtsanwälte PartG mbB
(86) Numéro de dépôt international: PCT/EP2014/074626
(87) Numéro de publication internationale: WO 2015/071420

(56) Documents cités:
- WO-A1-2010/003115

## Description

### DOMAINE DE L'INVENTION

La présente invention concerne un dispositif de test d'un module photovoltaïque à concentration, ainsi qu'un procédé de test mettant en oeuvre ledit dispositif.

### ARRIERE PLAN DE L'INVENTION

Un module photovoltaïque à concentration (CPV, acronyme du terme anglo-saxon « Concentrated PhotoVoltaic ») comprend essentiellement une cellule photovoltaïque (par exemple multi-jonctions) et un concentrateur destiné à concentrer le rayonnement solaire vers ladite cellule.

Dans le cas d'une cellule multi-jonctions, les différentes jonctions sont agencées en série, chacune des jonctions étant adaptée à une bande spectrale spécifique du rayonnement solaire.

Les cellules multi-jonctions, qui sont de plus petites dimensions que les cellules solaires en silicium conventionnelles, présentent l'avantage d'offrir un meilleur rendement, mais nécessitent pour fonctionner une intensité lumineuse plus élevée.

Dans un module CPV, les cellules sont associées à un concentrateur, par exemple une lentille de Fresnel, qui concentre le rayonnement solaire vers la cellule. Le document WO2010/003115A décrit un dispositif de test d'un module photovoltaïque. En outre, les modules photovoltaïque sont destinés à être montés sur un système suiveur de soleil (également appelé « tracker » dans la terminologie anglo-saxonne) de sorte à orienter de manière optimale le module en fonction de la trajectoire du soleil pour que les concentrateurs focalisent les rayons du soleil sur les cellules.

Lors de la fabrication de tels modules photovoltaïques, il est habituel de vérifier le fonctionnement et les performances de chaque module, en vue de détecter une éventuelle défaillance de l'une des jonctions, des défauts de qualité ou de positionnement des concentrateurs, ou toute autre anomalie du module avant que celui-ci ne soit expédié.

Il est fréquent que les modules soient combinés en étant montés totalement ou partiellement en série. Dans ce cas, les performances du système global seront limitées par l'élément le plus faible. Il peut donc s'avérer utile de sélectionner les modules devant être combinés afin qu'ils soient homogènes en réponse. Dans cet objectif, il est important de pouvoir mesurer la performance de ce module.

A cet effet, il est connu de simuler l'éclairement du soleil au moyen d'un dispositif d'éclairement généralement appelé « flasher », qui génère un faisceau lumineux présentant une irradiance, une distribution spectrale de puissance et une divergence angulaire proches de celles du soleil. Ces caractéristiques devront être conformes sur l'ensemble de la surface du module à tester.

Les modules CPV présents actuellement sur le marché présentent des dimensions relativement faibles (de l'ordre de 0,5 à 1,5 m²). II existe des dispositifs d'éclairement qui permettent de simuler l'éclairement solaire sur un module de ce type.

La société Soitec a mis sur le marché des modules solaires de grandes dimensions, présentant une surface de plusieurs m², constitués de plusieurs sous-modules CPV solidarisés par un châssis unique.

Ainsi, par exemple, un module de 8 m² peut être formé de deux rangées de six sous-modules, qui peuvent éventuellement être connectés en série.

II se pose donc le problème de pouvoir tester un module de grandes dimensions : les sous-modules étant connectés totalement ou partiellement en série et leur intégrité mécanique étant assurée par un châssis unique, ils ne peuvent être testés indépendamment.

D'autre part, il est important de garantir le fonctionnement de l'ensemble assemblé avant qu'il ne soit installé.

II est donc nécessaire de pouvoir vérifier les performances du module complet, en simulant un éclairement qui soit le plus proche possible du rayonnement solaire.

A cet égard, les contraintes que doit respecter le dispositif d'éclairement sont les suivantes :
- une irradiance comparable à celle produite par le soleil au niveau du sol, c'est-à-dire de l'ordre de 1 kW/m²,
- la reproduction du spectre solaire complet, de l'ultraviolet à l'infrarouge, en respectant les densités spectrales,
- une divergence angulaire proche de celle de la lumière solaire, c'est-à-dire de 0,5° (± 0,25°),
- une grande uniformité spatiale de l'irradiance (l'objectif étant une inhomogénéité de l'irradiance inférieure ou égale à 5%).

Les dispositifs d'éclairement connus ne répondent pas à ces exigences pour un module de grandes dimensions.

En effet, ces dispositifs offrent soit un champ plus réduit, soit des caractéristiques (notamment la divergence angulaire) trop éloignées de celles du soleil.

Une autre contrainte à prendre en compte pour concevoir le dispositif d'éclairement est la compacité de l'installation de test.

II pourrait être envisagé d'utiliser plusieurs dispositifs connus qui éclaireraient chacun une partie du module.

Cependant, se pose alors le problème de l'homogénéité de l'intensité lumineuse ainsi que celui des effets de bords dans les zones où ces différents dispositifs se côtoient.

En effet, non seulement chaque dispositif doit délivrer une intensité lumineuse très homogène, mais cette uniformité doit également être respectée d'un dispositif d'éclairement à l'autre.

Il est possible d'ajuster l'intensité lumineuse délivrée par chaque dispositif en modifiant la tension d'alimentation de chaque source ; cependant, cet ajustement affecte également le spectre lumineux.

Un but de l'invention est de concevoir un dispositif de test d'un module photovoltaïque à concentration de grandes dimensions, qui respecte les contraintes mentionnées ci-dessus, et qui offre notamment une très bonne homogénéité de l'intensité lumineuse, tout en étant compatible avec une installation de test compacte.

### BREVE DESCRIPTION DE L'INVENTION

Il est donc proposé un dispositif de test d'un module photovoltaïque à concentration comprenant une pluralité de sous-modules comportant chacun une pluralité d'ensembles d'une cellule photovoltaïque et d'un concentrateur agencé par rapport à la cellule pour concentrer vers ladite cellule un rayonnement arrivant en incidence normale.

Conformément à l'invention, ledit dispositif de test comprend :
- une pluralité de sources lumineuses,
- une pluralité de miroirs paraboliques couplés aux sources lumineuses de manière à renvoyer la lumière issue de chaque source dans une pluralité de faisceaux lumineux quasi collimatés vers le module à tester, dans une direction perpendiculaire à la surface dudit module,
chaque source lumineuse comprenant :
- un système optique présentant un axe optique et comprenant deux lentilles parallèles agencées de part et d'autre d'un diaphragme,
- une lampe agencée sur ledit axe optique,
- un réflecteur agencé sur ledit axe optique, du côté opposé au système optique par rapport à la lampe, ledit réflecteur étant mobile en translation le long de l'axe optique, de sorte à ajuster l'intensité lumineuse délivrée par la source en faisant varier la distance entre le réflecteur et la lampe,
- un boîtier contenant le système optique, la lampe et le réflecteur et comprenant un orifice de sortie du faisceau lumineux, ledit orifice étant agencé sur l'axe optique du système optique.

A cet effet, le dispositif de test comprend un support adapté pour maintenir le module photovoltaïque perpendiculairement au faisceau quasi collimaté renvoyé par chaque miroir.

Par faisceau quasi collimaté, on entend dans le présent texte un faisceau dont la divergence est faible, typiquement inférieure à 1°. Dans la présente invention, afin de reproduire la divergence du soleil, le faisceau quasi collimaté a une divergence de +/-0,25°.

De manière connue en elle-même, chaque faisceau quasi collimaté est obtenu en plaçant l'orifice de chaque source lumineuse au foyer ou au voisinage du foyer du miroir parabolique auquel il est couplé, l'homme du métier étant en mesure de définir les caractéristiques dimensionnelles de l'orifice et du couple miroir-source pour obtenir un tel faisceau quasi-collimaté.

Selon un mode de réalisation, la lampe est une lampe à éclat.

Le réflecteur peut être un miroir cylindrique ou sphérique.

Selon une forme d'exécution de l'invention, le dispositif comprend autant de miroirs paraboliques que de sources lumineuses, chaque source lumineuse étant agencée au foyer du miroir parabolique correspondant.

Selon un mode de réalisation, les sources lumineuses sont agencées selon deux rangées s'étendant horizontalement de part et d'autre de l'emplacement du module sur son support.

Les miroirs paraboliques sont alors agencés de sorte à former deux rangées horizontales en vis-à-vis de l'emplacement du module à tester sur le support.

Un autre objet concerne un procédé de test d'un module photovoltaïque à concentration comprenant une pluralité de sous-modules comportant chacun une pluralité d'ensembles d'une cellule photovoltaïque et d'un concentrateur agencé par rapport à la cellule pour concentrer vers ladite cellule un rayonnement arrivant en incidence normale, ledit procédé étant caractérisé en ce que l'on envoie vers ledit module, dans une direction perpendiculaire à la surface dudit module, une pluralité de faisceaux lumineux quasi collimatés au moyen d'une pluralité de sources lumineuses couplées à des miroirs paraboliques, chaque source lumineuse comprenant :
- un système optique présentant un axe optique et comprenant deux lentilles parallèles agencées de part et d'autre d'un diaphragme,
- une lampe agencée sur ledit axe optique,
- un réflecteur agencé sur ledit axe optique, du côté opposé au système optique par rapport à la lampe, ledit réflecteur étant mobile en translation le long de l'axe optique,
- un boîtier contenant le système optique, la lampe et le réflecteur et comprenant un orifice de sortie du faisceau lumineux, ledit orifice étant agencé sur l'axe optique du système optique,
et en ce que l'on uniformise au préalable l'intensité lumineuse délivrée par l'ensemble desdites sources lumineuses ponctuelles en ajustant, pour chaque source lumineuse, la distance entre le réflecteur et la lampe.

Selon une forme d'exécution, on utilise autant de sources lumineuses et de miroirs paraboliques que de sous-modules du module photovoltaïque à tester, chaque source lumineuse étant couplée à un miroir parabolique de sorte à envoyer un faisceau lumineux quasi collimaté vers un sous-module correspondant.

De manière particulièrement avantageuse, les sources lumineuses et les miroirs paraboliques sont agencés de sorte à ce que des zones non illuminées par les faisceaux quasi collimatés envoyés par les miroirs coïncident avec les zones séparant les sous-modules du module à tester.

De préférence, la surface du module à tester est supérieure ou égale à 3 m².

Selon un mode de réalisation, les cellules du module sont des cellules multi-jonctions.

### BREVE DESCRIPTION DES DESSINS

D'autres caractéristiques et avantages de l'invention ressortiront de la description détaillée qui va suivre, en référence aux dessins annexés sur lesquels :
- la figure 1A est un schéma de principe d'un module photovoltaïque à concentration comprenant plusieurs sous-modules connectés en série ;
- la figure 1B est un schéma de principe d'un ensemble cellule photovoltaïque - concentrateur appartenant à un sous-module d'un tel module,
- la figure 2 est une vue d'ensemble d'un dispositif de test selon l'invention,
- la figure 3 est un schéma de principe d'une source lumineuse d'un dispositif de test conforme à l'invention.

### DESCRIPTION DETAILLEE DE L'INVENTION

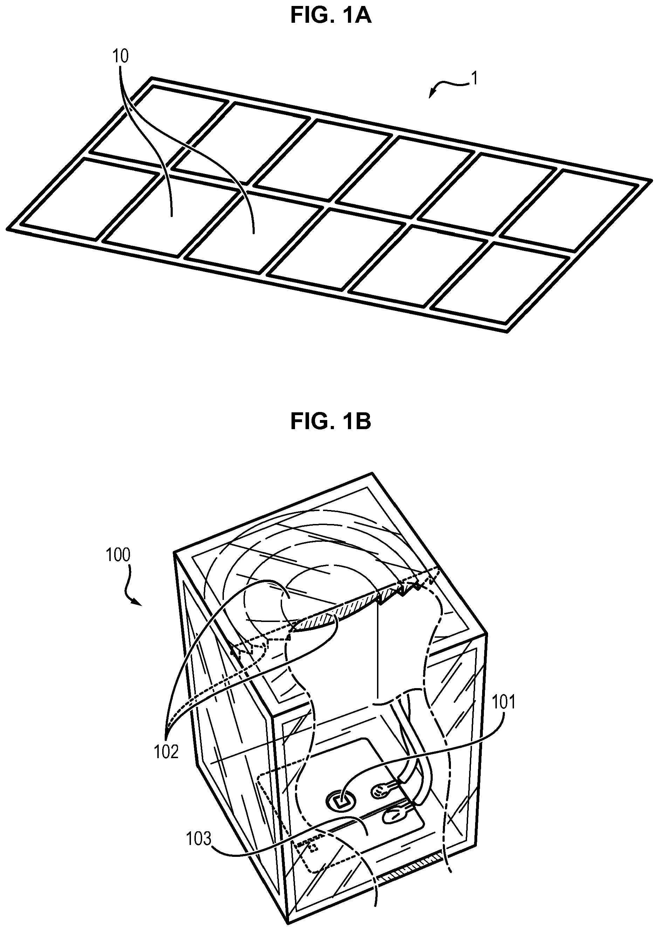

La figure 1A est un schéma de principe d'un module photovoltaïque que l'invention permet de tester.

Ledit module 1 à tester comprend une pluralité de sous-modules photovoltaïques à concentration 10.

Chaque sous-module 10 comprend une pluralité d'ensembles cellule - concentrateur.

Comme illustré sur la figure 1B, chaque ensemble 100 comprend essentiellement une cellule photovoltaïque 101 (par exemple multi-jonctions) et un concentrateur 102 destiné à concentrer vers ladite cellule 101 le rayonnement solaire arrivant en incidence normale. De manière optionnelle, la cellule 101 est placée sur un dissipateur de chaleur 103 pour limiter sa montée en température.

Le concentrateur 102 comprend par exemple une lentille de Fresnel.

Dans le présent texte, la surface du module à tester est la surface des concentrateurs.

Les sous-modules 10 formant le module 1 peuvent éventuellement être électriquement connectés en série ou en parallèle.

La surface de chaque sous-module 10 présente une forme généralement rectangulaire, dont la largeur et la hauteur sont respectivement comprises dans les gammes suivantes : entre 30 et 80 cm de largeur, par exemple 60 cm, et entre 60 et 150 cm de hauteur, par exemple 120 cm.

Les sous-modules 10 sont typiquement agencés sous forme de rangées et/ou colonnes pour former le module.

Par exemple, un module de 8 m² peut être formé de deux rangées de six sous-modules, chaque sous-module présentant une surface d'environ 0,7 m².

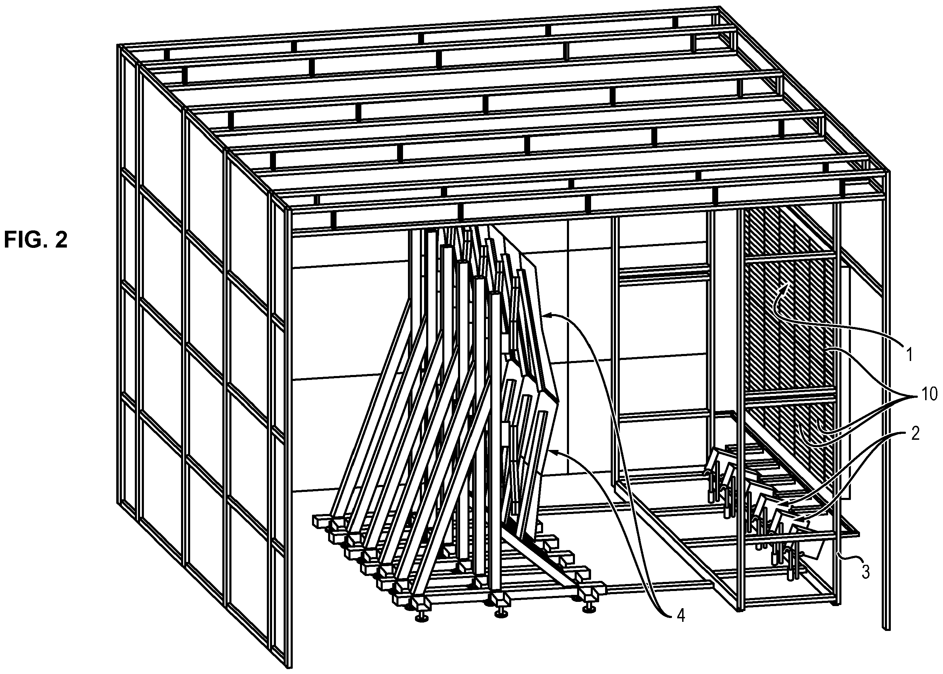

La figure 2 est une vue d'ensemble d'un dispositif de test conforme à l'invention.

Le dispositif comprend un support 3 pour le module 1 à tester.

De préférence, le support 3 est agencé de sorte que la surface du module à tester soit verticale.

Par « verticale », on entend dans le présent texte une direction perpendiculaire au plancher du bâtiment dans lequel le dispositif de test est installé.

En regard du support 3, le dispositif de test comprend une pluralité de sources lumineuses 2 et une pluralité de miroirs paraboliques 4 couplés aux sources lumineuses de manière à réfléchir la lumière issue de chaque source en un faisceau lumineux quasi collimaté dans une direction perpendiculaire à la surface du module..

Selon un mode de réalisation préféré, chaque source est agencée au foyer du miroir parabolique correspondant.

Dans ce cas, le dispositif de test comprend donc autant de sources que de miroirs.

Ceci permet d'utiliser une pluralité de miroirs identiques, dont la position et l'orientation sont ajustées de sorte à renvoyer vers le module à tester un faisceau quasi collimaté perpendiculaire à la surface dudit module.

Selon un autre mode de réalisation, chaque source lumineuse peut être couplée à plusieurs miroirs, dans la mesure où ces miroirs sont agencés de sorte que leurs foyers soient confondus, la source étant agencée à l'emplacement de ces foyers.

Dans le mode de réalisation illustré sur la figure 2, où le module 1 comprend deux rangées horizontales de six sous-modules 10, le dispositif de test comprend douze sources lumineuses 2 disposées selon deux rangées horizontales de part et d'autre du module 1, et douze miroirs paraboliques 4 disposés selon deux rangées horizontales en regard du module 1.

Chaque source et le miroir parabolique correspondant sont orientés l'un par rapport à l'autre de sorte que le faisceau lumineux renvoyé par le miroir soit perpendiculaire à la surface du sous-module correspondant.

La distance entre les sources et les miroirs paraboliques est définie de sorte que le faisceau lumineux quasi collimaté renvoyé par chaque miroir éclaire avec les caractéristiques souhaitées la totalité de la surface du sous-module correspondant.

Cette distance, ainsi que la surface des miroirs, dépend donc de la surface des sous-modules du module à tester.

Sans vouloir être limitatif, on considère qu'une distance de l'ordre de 2 à 6 mètres mesurée au sol entre les miroirs paraboliques et les sources lumineuses - qui détermine la majeure partie de la surface au sol du dispositif de test - est raisonnable.

Il n'est cependant pas indispensable que le nombre de sources lumineuses et de miroirs paraboliques soit identique au nombre de sous-modules du module photovoltaïque à tester.

En effet, si la surface de chaque sous-module est suffisamment faible, on peut prévoir qu'un couple source lumineuse - miroir parabolique éclaire plusieurs sous-modules tout en conservant un encombrement au sol acceptable du dispositif de test et une taille de miroir qui ne grève pas son coût de fabrication.

D'autre part, il peut exister des zones, à la frontière entre des faisceaux quasi collimatés adjacents, dans lesquelles l'intensité ne remplit pas les critères d'uniformité ou de divergence.

Dans ce cas, on agence avantageusement les sources lumineuses et les miroirs paraboliques de sorte à ce que des zones non illuminées par les faisceaux quasi collimatés envoyés par les miroirs coïncident avec les zones séparant les sous-modules du module à tester, qui ne sont pas fonctionnelles en termes de conversion photovoltaïque.

Pour des raisons d'assemblage des modules, il existe en effet, comme on peut le voir sur la figure 1A, un espace entre deux sous-modules 10 adjacents, au niveau duquel il ne se produit aucune conversion photovoltaïque.

Ainsi, si d'éventuels défauts d'uniformité se produisent dans ces zones, ces défauts n'ont pas d'effet négatif sur la qualité du test.

Pour permettre ce réglage, le dispositif de test est conçu de telle sorte qu'un ajustement de la position et de l'orientation de chaque miroir soit possible.

Un jeu est avantageusement prévu entre les miroirs pour permettre de tels ajustements.

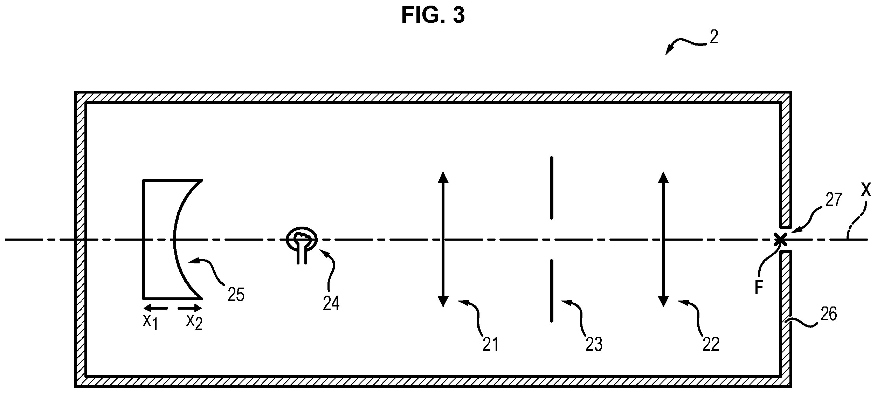

La figure 3 est un schéma de principe d'une source lumineuse capable de générer un faisceau lumineux ayant les caractéristiques requises.

Ladite source 2 comprend un système optique présentant un axe optique X et comprenant deux lentilles parallèles 21, 22 agencées de part et d'autre d'un diaphragme 23.

Une lampe 24 est agencée sur l'axe optique X ; on désignera par « première lentille » la lentille 21 la plus proche de la lampe et par « seconde lentille » la lentille 22 agencée de l'autre côté du diaphragme 23.

De manière avantageuse, la lampe 24 est une lampe à éclat. Cette lampe est sélectionnée pour sa capacité à produire le spectre lumineux ainsi que l'irradiance voulus. Par exemple la lampe 24 est une lampe à éclat au xénon.

Le diaphragme 23 est centré sur l'axe optique X et a pour fonction de ne sélectionner que la partie centrale du faisceau provenant de la première lentille, afin que chaque source lumineuse n'éclaire que le miroir parabolique à laquelle elle est appariée.

La source lumineuse comprend en outre un réflecteur 25 agencé sur l'axe optique X du côté opposé au système optique 21, 22, 23 par rapport à la lampe 24, de sorte à renvoyer vers le système optique 21, 22, 23 la lumière émise par la lampe dans la direction opposée.

Ledit réflecteur 25 est mobile en translation (schématisée par la flèche à double sens X₁, X₂) le long de l'axe optique X.

Le réflecteur peut consister en un miroir cylindrique, sphérique ou parabolique. Dans ce dernier cas, le miroir peut être un miroir parabolique de révolution ou un miroir cylindro-parabolique, c'est-à-dire dont une surface réglée dont la section est une parabole et dont les génératrices s'étendent dans un plan perpendiculaire au plan de ladite parabole.

Par exemple, ledit miroir est réalisé en aluminium poli.

Les avantages dudit réflecteur mobile dans la source sont les suivants :
- D'une part, on peut ajuster l'intensité lumineuse délivrée par la source en faisant varier la distance selon l'axe X entre le réflecteur 25 et la lampe 24.
- D'autre part, on collecte une plus grande quantité de lumière que ce qui serait récupérable avec une lampe seule.
- Enfin, il permet d'homogénéiser la lumière émise par la lampe afin de limiter la sensibilité à la géométrie de la lampe ainsi qu'aux erreurs de positionnement lors des changements de lampe.

L'ensemble du système optique 21, 22, 23, de la lampe 24 est du réflecteur 25 est contenu dans un boîtier 26.

Ledit boîtier comprend un orifice 27 agencé sur l'axe optique X de sorte que les différentes sources ne se perturbent pas entre elles, une source n'émettant de la lumière que sur un seul miroir.

L'orifice 27 a une taille qui peut être typiquement comprise entre 1 mm à 7 cm, de préférence 1 cm à 5 cm, en fonction de la distance entre la source et le miroir parabolique.

De manière avantageuse, la taille de l'orifice 27 est choisie de sorte à obtenir, par réflexion sur un miroir parabolique, un faisceau quasi collimaté présentant une divergence qui est sensiblement égale à celle du soleil (± 0,25°) sur une surface correspondant à celle de chaque sous-module du module à tester.

Par exemple, pour une distance entre le miroir parabolique et la source de 2,5 m, un orifice de la forme d'un disque de 3,5 cm de diamètre permet d'obtenir un faisceau quasi collimaté présentant la divergence souhaitée.

Ainsi, l'ensemble formé de la lampe 24, du réflecteur 25 et du système optique 21, 22, 23 et émettant un faisceau lumineux au travers de l'orifice 27 du boîtier forme une source lumineuse ayant les caractéristiques requises pour la mise en oeuvre du test de chaque sous-module.

L'homme du métier est à même de dimensionner les différents composants de la source pour qu'elle ait les caractéristiques requises.

Chaque source lumineuse étant agencée au foyer - ou au voisinage dudit foyer - d'un miroir parabolique respectif, chaque miroir réfléchit la lumière émise par la source correspondante sous la forme d'un faisceau quasi collimaté.

L'orientation des miroirs paraboliques est définie de sorte que chaque faisceau quasi collimaté soit perpendiculaire à la surface du module à tester.

Pour faire en sorte que l'intensité de l'ensemble des faisceaux quasi collimatés soit uniforme (c'est-à-dire qu'il existe une différence entre l'intensité la plus forte et l'intensité la plus faible parmi l'ensemble des faisceaux qui soit inférieure à 5%), on ajuste au préalable, pour chaque source lumineuse, l'intensité émise par ladite source.

Cet ajustement est réalisé par le réglage de la distance entre chaque lampe 24 et le réflecteur 25 correspondant.

L'intensité de chaque source est mesurée au moyen d'un capteur étalonné prévu à cet effet.

Par exemple, on définit une intensité cible et l'on fait en sorte que l'intensité de chaque faisceau soit comprise dans une gamme d'intensité de 5% autour de l'intensité cible.

Pour réaliser un test d'un module photovoltaïque, on installe ledit module sur le support et l'on réalise les connexions électriques nécessaires pour permettre d'enregistrer sa réponse à un éclairement simulant le soleil.

On règle si nécessaire la position et l'orientation des miroirs pour éclairer la totalité de la surface de chaque sous-module.

On vérifie en outre que l'ensemble des sources lumineuses présente l'uniformité d'intensité requise.

Cette vérification est effectuée automatiquement, par le capteur de mesure d'intensité mentionné plus haut, à chaque mesure d'un sous-module.

Cette vérification n'est pas nécessairement réalisée avant chaque test d'un nouveau module.

En effet, une fois que l'uniformité de l'intensité a été réglée pour un ensemble de sources donné (par exemple à la mise en service du dispositif de test, et/ou après le remplacement d'une source lumineuse ou d'un composant d'une telle source), on peut considérer que cette uniformité ne variera pas au cours du temps.

Le cas échéant, si cette vérification met en évidence un défaut d'uniformité, on ajuste l'intensité d'une ou plusieurs sources lumineuses afin d'obtenir l'uniformité requise.

Une fois que les éventuels réglages nécessaires ont été effectués, on déclenche simultanément les lampes de l'ensemble des sources.

Le faisceau émis par chaque source lumineuse est renvoyé par le miroir parabolique correspondant sous la forme d'un faisceau quasi collimaté vers le sous-module correspondant, dans une direction perpendiculaire à la surface du module.

On enregistre alors les caractéristiques courant-tension de chaque sous-module, puis on traite les résultats pour déterminer la puissance électrique que le module est capable de fournir.

## Revendications

1. Dispositif de test d'un module photovoltaïque à concentration (1) comprenant une pluralité de sous-modules (10) comportant chacun une pluralité d'ensembles d'une cellule photovoltaïque (101) et d'un concentrateur (102) agencé par rapport à la cellule pour concentrer vers ladite cellule un rayonnement arrivant en incidence normale, ledit dispositif de test comprenant:
- une pluralité de sources lumineuses (2),
- une pluralité de miroirs paraboliques (4) couplés aux sources lumineuses (2) de manière à renvoyer la lumière issue de chaque source (2) dans une pluralité de faisceaux lumineux quasi collimatés vers le module à tester, dans une direction perpendiculaire à la surface dudit module (1),
chaque source lumineuse (2) comprend :
- un système optique présentant un axe optique (X) et comprenant deux lentilles (21, 22) parallèles agencées de part et d'autre d'un diaphragme (23),
- une lampe (24) agencée sur ledit axe optique (X),
- un réflecteur (25) agencé sur ledit axe optique (X), du côté opposé au système optique (21, 22, 23) par rapport à la lampe (24), ledit réflecteur (25) étant mobile en translation le long de l'axe optique (X), de sorte à ajuster l'intensité lumineuse délivrée par la source (2) en faisant varier la distance entre le réflecteur (25) et la lampe (24),
- un boîtier (26) contenant le système optique (21, 22, 23), la lampe (24) et le réflecteur (25) et comprenant un orifice (27) de sortie du faisceau lumineux, ledit orifice (27) étant agencé sur l'axe optique (X) du système optique (21, 22, 23).

2. Dispositif selon la revendication 1, **caractérisé en ce que** la lampe est une lampe à éclat.

3. Dispositif selon l'une des revendications 1 ou 2, **caractérisé en ce que** le réflecteur est un miroir parabolique.

4. Dispositif selon l'une des revendications 1 à 3, **caractérisé en ce qu'**il comprend autant de miroirs paraboliques que de sources lumineuses, chaque source lumineuse étant agencée au foyer du miroir parabolique correspondant.

5. Dispositif selon l'une des revendications 1 à 4, **caractérisé en ce qu'**il comprend un support pour le module à tester et **en ce que** les sources lumineuses sont agencées selon deux rangées s'étendant horizontalement de part et d'autre de l'emplacement du module sur ledit support.

6. Dispositif selon la revendication 5, **caractérisé en ce que** les miroirs paraboliques sont agencés de sorte à former deux rangées horizontales en vis-à-vis de l'emplacement du module à tester sur le support.

7. Procédé de test d'un module photovoltaïque à concentration (1) comprenant une pluralité de sous-modules (10) comportant chacun une pluralité d'ensembles (100) d'une cellule photovoltaïque (101) et d'un concentrateur (102) agencé par rapport à la cellule pour concentrer vers ladite cellule un rayonnement arrivant en incidence normale, ledit procédé étant **caractérisé en ce que** l'on envoie vers ledit module (1), dans une direction perpendiculaire à la surface dudit module, une pluralité de faisceaux lumineux quasi collimatés au moyen d'une pluralité de sources lumineuses (2) couplées à des miroirs paraboliques (4), chaque source lumineuse (2) comprenant :
- un système optique présentant un axe optique (X) et comprenant deux lentilles parallèles (21, 22) agencées de part et d'autre d'un diaphragme (23),
- une lampe (24) agencée sur ledit axe optique (X),
- un réflecteur (25) agencé sur ledit axe optique (X), du côté opposé au système optique (21, 22, 23) par rapport à la lampe (24), ledit réflecteur (25) étant mobile en translation le long de l'axe optique (X),
- un boîtier (26) contenant le système optique (21, 22, 23), la lampe (24) et le réflecteur (25) et comprenant un orifice (27) de sortie du faisceau lumineux, ledit orifice (27) étant agencé sur l'axe optique (X) du système optique (21, 22, 23),
et **en ce que** l'on uniformise au préalable l'intensité lumineuse délivrée par l'ensemble desdites sources lumineuses ponctuelles (2) en ajustant, pour chaque source lumineuse (2), la distance entre le réflecteur (25) et la lampe (24).

8. Procédé selon la revendication 7, **caractérisé en ce que** l'on utilise autant de sources lumineuses (2) et de miroirs paraboliques (4) que de sous-modules (10) du module photovoltaïque (1) à tester, chaque source lumineuse (2) étant couplée à un miroir parabolique (4) de sorte à envoyer un faisceau lumineux quasi collimaté vers un sous-module (10) correspondant.

9. Procédé selon la revendication 8, **caractérisé en ce que** les sources lumineuses et les miroirs paraboliques sont agencés de sorte à ce que des zones non illuminées par les faisceaux quasi collimatés envoyés par les miroirs coïncident avec les zones séparant les sous-modules du module à tester.

10. Procédé selon l'une des revendications 7 à 9, **caractérisé en ce que** la surface du module à tester est supérieure ou égale à 3m².

11. Procédé selon l'une des revendications 7 à 10, **caractérisé en ce que** les cellules du module sont des cellules multi-jonctions.

## Patentansprüche

1. Vorrichtung zum Testen eines konzentrierenden Photovoltaikmoduls (1), das mehrere Untermodule (10) umfasst, die jeweils mehrere Anordnungen einer Photovoltaikzelle (101) und eines Konzentrators (102), der bezüglich der Zelle so angeordnet ist, dass er eine senkrecht einfallende Strahlung in Richtung der Zelle konzentriert, aufweisen, wobei die Vorrichtung zum Testen umfasst:
- mehrere Lichtquellen (2),
- mehrere Parabolspiegel (4), die mit den Lichtquellen (2) derart gekoppelt sind, dass sie das von den einzelnen Quellen (2) abgegebene Licht in mehreren quasikollimatierten Lichtbündeln zu dem zu testenden Modul hin in einer zur Oberfläche des Moduls (1) senkrechten Richtung zurückstrahlen,
wobei jede Lichtquelle (2) umfasst:
- ein optisches System, das eine optische Achse (X) aufweist und zwei parallele Linsen (21, 22) umfasst, die beiderseits einer Membran (23) angeordnet sind,
- eine Lampe (24), die auf der optischen Achse (X) angeordnet ist,
- einen Reflektor (25), der auf der optischen Achse(X) auf der dem optischen System (21, 22, 23) bezüglich der Lampe (24) gegenüberliegenden Seite angeordnet ist, wobei der Reflektor (25) entlang der optischen Achse (X) translatorisch beweglich ist, um die von der Quelle (2) gelieferte Lichtstärke einzustellen, indem bewirkt wird, dass sich der Abstand zwischen dem Reflektor (25) und der Lampe (24) ändert,
- ein Gehäuse (26), welches das optische System (21, 22, 23), die Lampe (24) und den Reflektor (25) enthält und eine Öffnung (27) für den Austritt des Lichtbündels umfasst, wobei diese Öffnung (27) auf der optischen Achse (X) des optischen Systems (21, 22, 23) angeordnet ist.

2. Vorrichtung nach Anspruch 1, **dadurch gekennzeichnet, dass** die Lampe eine Blitzlampe ist.

3. Vorrichtung nach einem der Ansprüche 1 oder 2, **dadurch gekennzeichnet, dass** der Reflektor ein Parabolspiegel ist.

4. Vorrichtung nach einem der Ansprüche 1 bis 3, **dadurch gekennzeichnet, dass** sie ebenso viele Parabolspiegel wie Lichtquellen umfasst, wobei jede Lichtquelle im Brennpunkt des entsprechenden Parabolspiegels angeordnet ist.

5. Vorrichtung nach einem der Ansprüche 1 bis 4, **dadurch gekennzeichnet, dass** sie einen Träger für das zu testende Modul umfasst, und dadurch, dass die Lichtquellen in zwei Reihen angeordnet sind, die sich horizontal beiderseits der Position des zu testenden Moduls auf dem Träger erstrecken.

6. Vorrichtung nach Anspruch 5, **dadurch gekennzeichnet, dass** die Parabolspiegel derart angeordnet sind, dass sie zwei horizontale Reihen gegenüber der Position des zu testenden Moduls auf dem Träger bilden.

7. Verfahren zum Testen eines konzentrierenden Photovoltaikmoduls (1), das mehrere Untermodule (10) umfasst, die jeweils mehrere Anordnungen (100) einer Photovoltaikzelle (101) und eines Konzentrators (102), der bezüglich der Zelle so angeordnet ist, dass er eine senkrecht einfallende Strahlung in Richtung der Zelle konzentriert, aufweisen, wobei das Verfahren **dadurch gekennzeichnet ist, dass** zu dem Modul (1) hin in einer zur Oberfläche des Moduls senkrechten Richtung mittels mehrerer Lichtquellen (2), die mit Parabolspiegeln (4) gekoppelt sind, mehrere quasi-kollimatierte Lichtbündel gesendet werden, wobei jede Lichtquelle (2) umfasst:
- ein optisches System, das eine optische Achse (X) aufweist und zwei parallele Linsen (21, 22) umfasst, die beiderseits einer Membran (23) angeordnet sind,
- eine Lampe (24), die auf der optischen Achse (X) angeordnet ist,
- einen Reflektor (25), der auf der optischen Achse (X) auf der dem optischen System (21, 22, 23) bezüglich der Lampe (24) gegenüberliegenden Seite angeordnet ist, wobei der Reflektor (25) entlang der optischen Achse (X) translatorisch beweglich ist,
- ein Gehäuse (26), welches das optische System (21, 22, 23), die Lampe (24) und den Reflektor (25) enthält und eine Öffnung (27) für den Austritt des Lichtbündels umfasst, wobei diese Öffnung (27) auf der optischen Achse (X) des optischen Systems (21, 22, 23) angeordnet ist,
und dadurch, dass im Voraus bewirkt wird, dass die Lichtstärke, die von der Gesamtheit der punktförmigen Lichtquellen (2) geliefert wird, gleichmäßig ist, indem für jede Lichtquelle (2) der Abstand zwischen dem Reflektor (25) und der Lampe (24) eingestellt wird.

8. Verfahren nach Anspruch 7, **dadurch gekennzeichnet, dass** ebenso viele Lichtquellen (2) und Parabolspiegel (4) verwendet werden, wie Untermodule (10) des zu testenden Photovoltaikmoduls (1) vorhanden ist, wobei jede Lichtquelle (2) mit einem Parabolspiegel (4) so gekoppelt ist, dass sie ein quasi-kollimatiertes Lichtbündel zu einem entsprechenden Untermodul (10) hin sendet.

9. Verfahren nach Anspruch 8, **dadurch gekennzeichnet, dass** die Lichtquellen und die Parabolspiegel derart angeordnet sind, dass Bereiche, die nicht von den quasikollimatierten Lichtbündeln beleuchtet werden, die von den Spiegeln gesendet werden, mit den Bereichen zusammenfallen, welche die Untermodule des zu testenden Moduls trennen.

10. Verfahren nach einem der Ansprüche 7 bis 9, **dadurch gekennzeichnet, dass** die Oberfläche des zu testenden Moduls größer oder gleich 3m² ist.

11. Verfahren nach einem der Ansprüche 7 bis 10, **dadurch gekennzeichnet, dass** die Zellen des Moduls Multijunction-Zellen sind.

## Claims

1. Device for testing a concentrating photovoltaic module (1) comprising a plurality of submodules (10) each comprising a plurality of assemblies of a photovoltaic cell (101) and of a concentrator (102) that is arranged with respect to the cell to concentrate onto said cell radiation arriving at normal incidence, said testing device comprising:
- a plurality of light sources (2); and
- a plurality of parabolic mirrors (4) that are coupled to the light sources (2) so as to redirect the light generated by each source (2) in a plurality of almost collimated light beams towards the module to be tested, in a direction that is perpendicular to the surface of said module (1);
each light source (2) comprises:
- an optical system having an optical axis (X) and comprising two parallel lenses (21, 22) that are arranged on either side of a diaphragm (23);
- a lamp (24) that is arranged on said optical axis (X);
- a reflector (25) that is arranged on said optical axis (X), on the side opposite the optical system (21, 22, 23) with respect to the lamp (24), said reflector (25) being translatably movable along the optical axis (X), so as to allow the light intensity delivered by the source (2) to be adjusted by varying the distance between the reflector (25) and the lamp (24); and
- a casing (26) containing the optical system (21, 22, 23), the lamp (24) and the reflector (25) and comprising an exit orifice (27) for the light beam, said orifice (27) being arranged on the optical axis (X) of the optical system (21, 22, 23).

2. Device according to Claim 1, **characterized in that** the lamp is a flashlamp.

3. Device according to either of Claims 1 and 2, **characterized in that** the reflector is a parabolic mirror.

4. Device according to one of Claims 1 to 3, **characterized in that** it comprises as many parabolic mirrors as there are light sources, each light source being arranged at the focal point of the corresponding parabolic mirror.

5. Device according to one of Claims 1 to 4, **characterized in that** it comprises a holder for the module to be tested and **in that** the light sources are arranged in two rows extending horizontally on either side of the position of the module on said holder.

6. Device according to Claim 5, **characterized in that** the parabolic mirrors are arranged so as to form two horizontal rows facing the position of the module to be tested on the holder.

7. Method for testing a concentrating photovoltaic module (1) comprising a plurality of submodules (10) each including a plurality of assemblies (100) of a photovoltaic cell (101) and of a concentrator (102) that is arranged with respect to the cell to concentrate onto said cell radiation arriving at normal incidence, said method being **characterized in that** a plurality of almost collimated light beams are sent towards said module (1), in a direction perpendicular to the surface of said module, by means of a plurality of light sources (2) that are coupled to parabolic mirrors (4), each light source (2) comprising:
- an optical system having an optical axis (X) and comprising two parallel lenses (21, 22) that are arranged on either side of a diaphragm (23);
- a lamp (24) that is arranged on said optical axis (X);
- a reflector (25) that is arranged on said optical axis (X), on the side opposite the optical system (21, 22, 23) with respect to the lamp (24), said reflector (25) being translatably movable along the optical axis (X); and
- a casing (26) containing the optical system (21, 22, 23), the lamp (24) and the reflector (25) and comprising an exit orifice (27) for the light beam, said orifice (27) being arranged on the optical axis (X) of the optical system (21, 22, 23);
and **in that** the light intensity delivered by all of said point light sources (2) is made uniform beforehand by adjusting, for each light source (2), the distance between the reflector (25) and the lamp (24).

8. Method according to Claim 7, **characterized in that** as many light sources (2) and parabolic mirrors (4) are used as there are submodules (10) of the photovoltaic module (1) to be tested, each light source (2) being coupled to a parabolic mirror (4) so as to send an almost collimated light beam towards a corresponding submodule (10).

9. Method according to Claim 8, **characterized in that** the light sources and the parabolic mirrors are arranged so that zones not illuminated by the almost collimated beams sent by the mirrors coincide with the zones separating the submodules of the module to be tested.

10. Method according to one of Claims 7 to 9, **characterized in that** the area of the module to be tested is larger than or equal to 3 m².

11. Method according to one of Claims 7 to 10, **characterized in that** the cells of the module are multi-junction cells.
